(19) Europäisches Patentamt
European Patent Office
Office européen des brevets

(11) **EP 3 889 630 B1**

(12) **EUROPÄISCHE PATENTSCHRIFT**

(45) Veröffentlichungstag und Bekanntmachung des Hinweises auf die Patenterteilung:
**07.09.2022   Patentblatt 2022/36**

(21) Anmeldenummer: **21165243.3**

(22) Anmeldetag: **26.03.2021**

(51) Internationale Patentklassifikation (IPC):
***G01R 33/30*** (2006.01)

(52) Gemeinsame Patentklassifikation (CPC):
**G01R 33/307**

(54) **MAGNETISCH-KOMPENSIERTER NMR-ROTOR UND VERFAHREN ZUR AUSLEGUNG UND HERSTELLUNG**

MAGNETIC-COMPENSATED NMR ROTOR AND METHOD OF DESIGN AND MANUFACTURE

ROTOR RMN MAGNÉTIQUEMENT COMPENSÉ ET PROCÉDÉ DE CONCEPTION ET DE FABRICATION

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **03.04.2020   DE 102020204379**

(43) Veröffentlichungstag der Anmeldung:
**06.10.2021   Patentblatt 2021/40**

(73) Patentinhaber: **Bruker Switzerland AG**
**8117 Fällanden (CH)**

(72) Erfinder:
  • **Wikus, Patrick**
    **8309 Nürensdorf (CH)**

  • **Baumann, Daniel Guy**
    **8117 Fällanden (CH)**
  • **Mayer, Markus**
    **8625 Gossau (CH)**
  • **Woodtli, Martin**
    **8617 Mönchaltdorf (DE)**
  • **Schauwecker, Robert**
    **8004 Zürich (CH)**

(74) Vertreter: **Kohler Schmid Möbus Patentanwälte Partnerschaftsgesellschaft mbB**
**Gropiusplatz 10**
**70563 Stuttgart (DE)**

(56) Entgegenhaltungen:
**JP-A- 2013 205 223     US-A- 5 831 434**
**US-B2- 6 741 079**

EP 3 889 630 B1

**Beschreibung**

Die Erfindung betrifft einen NMR-Rotor mit einer Aufnahme zur Einführung eines Probenbehälters mit Probensubstanz für NMR-Messungen in einem homogenen Bereich eines NMR-Magnetfelds mit Flussdichte B, dessen Feldvektor im homogenen Bereich in vertikaler Richtung entlang einer z-Achse verläuft, wobei der NMR-Rotor beim Einbringen des Probenbehälters in den homogenen Bereich des Magnetfelds Bereiche mit inhomogenen Magnetfeldanteilen und zumindest einem Flussdichtegradienten dB/dz durchläuft.

Ein solcher NMR-Rotor, im Stand der Technik auch "Spinner" genannt, ist bereits bekannt, etwa aus den Druckschriften US 6 741 079 B2 ≈ DE 101 30 283 C1 (= Referenz [1]) sowie auch aus US 5 517 856 A ≈ DE 195 09 062 C2 (= Referenz [2]), wo auch unterschiedliche Probenhalter beschrieben sind, wobei ein Probenhalter dort den Rotor und den Probenbehälter umfasst.

Hintergrund der Erfindung

Die vorliegende Erfindung befasst sich ganz allgemein mit dem Gebiet der Kernspinresonanz (nuclear magnetic resonance = "NMR"), insbesondere mit NMR-Rotoren zur Einführung eines Probenbehälters mit Probensubstanz für NMR-Messungen. Die NMR-Spektroskopie stellt ein leistungsfähiges Verfahren der instrumentellen Analytik dar, insbesondere zur Analyse von Proben-Zusammensetzungen oder zur Strukturbestimmung von Stoffen in Proben.

Die Probensubstanz wird typischerweise in fester oder flüssiger Form in ein im Wesentlichen zylindrisches Probenröhrchen gefüllt. Zur Messung wird sie in den Messbereich eines NMR-Probenkopfs einer NMR-Apparatur verbracht. Dort ist die Probensubstanz einem starken, in einer z-Richtung homogenen, statischen Magnetfeld mit Flussdichte $B_0$ ausgesetzt, wodurch es zur Ausrichtung von Kernspins in der Probensubstanz kommt. Sodann werden hochfrequente elektromagnetische Impulse in die Probe eingestrahlt. Dies erzeugt wiederum hochfrequente elektromagnetische Felder, welche in der NMR-Apparatur detektiert werden. Aus den detektierten HF-Feldern können Informationen über die Eigenschaften der Probe erhalten werden. Insbesondere kann aus der Lage und Intensität von NMR-Linien auf die chemische Zusammensetzung sowie die chemischen Bindungsverhältnisse in der Probe geschlossen werden; siehe etwa US 9 500 726 B2 ≈ DE 10 2013 204 131 B3 (= Referenz [3]).

Eine annähernd "klassische" Anordnung aus einer NMR Messkammer, einem Rotor und einem Probenbehälter ist in der US 6,686,740 B2 ≈ DE 101 11 674 C2 ≈ EP 1 239 295 B1 (= Referenz [4]) beschrieben, hier allerdings in Kombination mit einem "mounting sleeve". Es werden keine speziellen Maßnahmen getroffen, um Proben in Systeme mit hohen Werten des Produkts B·dB/dz einführen zu können.

Ähnliche Vorrichtungen mit einem Rotor für NMR Proben sind in der US 4 806 868 A, der US-A 4 275 350 A, der JP 61023952 A, der US 2004 / 0 178 793 A1  und der US 3 681 683 A (= Referenz [5]) beschrieben. Bei diesem Stand der Technik wird der Fokus allerdings auf die Probenrotation und teilweise auch auf deren Regelung gelegt. Zum Beispiel wird beschrieben, wie der Rotor während der Rotation auf einem Gaspolster gelagert ist. Auch hier werden wiederum keine speziellen Maßnahmen getroffen, um Proben in Systeme mit hohem B·dB/dz einführen zu können.

In der JP 2001 235 526 A (= Referenz [6]) ist eine Vorrichtung beschrieben, bei der die NMR Probe mit einem "Operation Stick" in das Messvolumen eingebracht wird. Mit einem solchen "Operation Stick" wird kein pneumatischer Inject/Eject benötigt, und Widerstände (z.B. aufgrund magnetischer Kräfte) können leicht überwunden werden. Bei Hochfeldmagneten, bei denen B·dB/dz üblicherweise besonders groß ist, ist eine solche Vorrichtung jedoch sehr unpraktisch, da diese Magnete üblicherweise eine große räumliche Ausdehnung besitzen und der "Operation Stick" eine Länge von mehreren Metern aufweisen müsste. Dies wirkt sich z.B. sehr nachteilig auf die am Aufstellort benötigte Deckenhöhe aus.

In der US 2002 / 0 063 561 A1 (= Referenz [7]) wird eine Vorrichtung zum axialen Transport von NMR Proben beschrieben, mit deren Hilfe NMR Proben ins Messvolumen eines NMR Spektrometers transferiert werden können. Auch mit dieser Vorrichtung können Widerstände (z.B. aufgrund magnetischer Kräfte) überwunden werden. Nachteilig an der in Referenz [7] beschriebenen Vorrichtung ist, dass diese aufwändig und - wegen des Einsatzes beweglicher Teile - auch fehleranfällig und weniger zuverlässig ist als eine rein pneumatische Lösung. Außerdem kommen Teile der Transportvorrichtung dem Messvolumen nahe, was die Qualität des dort herrschenden Magnetfelds (vor allem dessen Homogenität) negativ beeinflusst. Für den Ein- und Ausbau der Transportvorrichtung ist außerdem eine gewisse Deckenhöhe am Aufstellort nötig.

In JP 2006 029 964 A (= Referenz [8]) wird vorgeschlagen, direkt in die zu untersuchende Substanz oder auf die Oberfläche des Probenröhrchens ein Material aufzubringen, dessen magnetische Eigenschaften (Diamagnetismus, Paramagnetismus, Ferromagnetismus) beeinflusst werden können, um die NMR Relaxationszeit der zu untersuchenden Substanz (typischerweise Fullerene oder Carbon-Nanotubes) zu verkürzen. Hier werden also die Eigenschaften der Einheit aus Probenröhrchens und Probensubstanz gezielt verändert, allerdings nicht unter besonderer Berücksichtigung des B*dB/dz Profils entlang der Magnetfeldachse z. Außerdem wird das Material mit den speziellen magnetischen Eigenschaften laut Referenz [8] auf das Röhrchen aufgebracht oder in die zu untersuchende Substanz gemischt und ist somit nicht im NMR-Rotor als solchem integriert.

In der US 7 656 158 B2 ≈ EP 1 918 731 B1 (= Referenz [9]) ist eine Vorrichtung beschrieben, bei der das Behältnis der zu untersuchenden NMR Substanz (also z.B. das Probenröhrchen) mit einem Material mit einer speziellen magnetischen Suszeptibilität beschichtet wird, um Feldstörungen im Inneren des Behältnisses (unter Berücksichtigung der magnetischen Suszeptibiliät der Probensubstanz selbst sowie der Umgebung) klein zu halten. Allerdings erfolgt dies nicht unter besonderer Berücksichtigung der Größe von B*dB/dz Profils entlang der Magnetfeldachse z. Außerdem wird das Material mit den speziellen magnetischen Eigenschaften laut diesem Stand der Technik auf das Röhrchen aufgebracht und ist somit wiederum nicht im NMR-Rotor als solchem integriert.

Ähnlich wie in Referenz [9] wird auch in der US 2009 / 0 066 333 A1 (= Referenz [10]) bei der Materialauswahl auf die magnetische Suszeptibilität geachtet - vor allem bei der Materialauswahl der Kappen, die die zu untersuchende Substanz in dem Probenröhrchen axial begrenzen. Hier steht allerdings wieder die Homogenität des Magnetfelds am Ort der zu untersuchenden Substanz im Fokus, und nicht die Kräfte, die beim Einbringen eines NMR-Rotors mit Probenbehälter und Probensubstanz in den Messbereich wirken. Das B*dB/dz Profil entlang der Magnetfeldachse findet keine Berücksichtigung. Außerdem wird das Material mit den speziellen magnetischen Eigenschaften wiederum nicht im NMR-Rotor als solchem integriert.

JP 2009 103 517 A (= Referenz [12]) offenbart ein Prinzip, bei welchem durch die Kombination eines paramagnetischen und diamagnetischen Materials in einer NMR-Spule sich die magnetischen Wirkungen bzw. die Suszeptibilität gegenseitig aufheben, wodurch die Güte der NMR-Spule (Q value) optimiert wird. Für den Fachmann ergibt sich daraus jedoch nicht die Veranlassung, dieses Prinzip auf einen NMR-Rotor zu übertragen, wie er etwa in DE 10 2014 201 076 B3 (= Referenz [13]) beschrieben ist.

Eine hohe Qualität der NMR-Messung hängt unter anderem davon ab, dass die NMR-Probe gut temperiert ist (hohe zeitliche Temperaturstabilität, keine Temperaturgradienten in der Probensubstanz), dass die Probe während des NMR-Experiments ruhig und ohne translatorische Relativbewegung zum Magnetfeld und/oder den RF-Spulen im magnetischen Zentrum sitzt, und dass die Probe im magnetischen Zentrum zur Ausmittelung von Off-Axis Gradienten rotiert werden kann (mit typischerweise 20 - 50 Hz) und dabei äußerst rund läuft und nicht schlägt.

Üblicherweise wird dieses Problem so gelöst, dass die Probensubstanz in ein Glasröhrchen gefüllt wird. Ein typisches NMR Messröhrchen ist in der US 2012 / 0 194 194 A1 (= Referenz [11]) beschrieben. Das Glasröhrchen wir anschließend verschlossen, entweder mit einem Stopfen oder durch Heiß-Verschmelzen des offenen Endes. Danach wird das Glasröhrchen in einen rotierbaren NMR-Rotor, z.B. aus einem Kunststoff wie POM, PEEK, PCTFE oder aus Keramik, eingespannt. Diese Einheit aus NMR-Rotor und Probenröhrchen kann pneumatisch -also durch einen Gasstrom- in der Magnetbohrung einer NMR-Apparatur auf und ab bewegt werden. Der Gasstrom ("Lift") ist dabei üblicherweise von unten auf die Einheit aus NMR-Rotor und Probenröhrchen gerichtet, damit der Auftrieb, den der Gasstrom erzeugt, dem Gewicht der Einheit entgegenwirken kann. So kann die Probe langsam ins Magnetzentrum eingebracht werden, und nach der Messung wieder ausgeworfen werden.

Wenn die Probe im Magnetzentrum der NMR-Apparatur liegt, kontaktiert der NMR-Rotor eine "Turbine". Über mehrere tangentiale Gaskanäle in der Turbine und über eine separate Quelle, die mit einem Gasfluss beaufschlagt werden können, kann der NMR-Rotor -und damit auch das Probenröhrchen mit der Probensubstanz- in Rotation versetzt werden. Dies hilft dabei, möglicherweise vorhandene Off-Axis Gradienten im Magnetfeld auszumitteln, und auch bei deren Vorhandensein schmale Linien im NMR-Spektrum zu erzielen. Optische Markierungen zur Messung der Drehzahl mittels einer Glasfaser sind ebenfalls am NMR-Rotor angebracht.

Wie schon oben erwähnt, ist für eine qualitativ hochwertige NMR-Messung des Weiteren eine gute Temperierung der Probe wichtig. Dabei ist es erforderlich, dass die Temperatur der Probe über die gesamte Dauer des NMR-Experiments möglichst konstant bleibt, um ein "Wandern" der Linien im Spektrum zu vermeiden, und möglichst nahe an einem gewünschten Sollwert liegt, um unterschiedliche Spektren miteinander vergleichbar zu machen. Außerdem muss die Temperatur über die räumliche Erstreckung der Probensubstanz möglichst konstant sein, um Linienverbreiterung und Konvektion in der Probensubstanz zu vermeiden.

Üblicherweise ist das NMR-Röhrchen im Durchmesser ≤ 10 mm und die Füllhöhe mit Probensubstanz liegt typischerweise zwischen 20 mm und 80 mm. Die Temperierung der Probe wird herkömmlich mittels eines dritten Gasstroms sichergestellt, der auf die gewünschte Temperatur vortemperiert wird, und dann von unten an der Außenseite des Probenröhrchens entlangstreicht. Störgrößen in der Temperaturregelung sind zum Beispiel die Dissipation von Leistung in der Probensubstanz selbst, z.B. durch die RF-Pulse, Dissipation in den elektrischen Shimspulen oder Wärmeabfluss in die Wärmesenke, die durch gekühlte RF-Spulen im Probenkopf gebildet wird.

Die Turbine -und deshalb auch der NMR-Rotor- liegt oberhalb des magnetischen Zentrums, typischerweise zwischen 30 mm und 200 mm entfernt. Der NMR-Rotor liegt meist also nicht mehr im homogenen "Plateau" des Magnetfelds, sondern in einem Bereich, in dem das Magnetfeld bereits einen axialen Gradienten aufweist.

Im Betrieb wirken mehrere Kräfte auf die Einheit aus Probenröhrchen und NMR-Rotor:

- Das Gewicht der Einheit aus Probe und NMR-Rotor, welches eine nach unten gerichtete Kraft erzeugt

- Reibungskräfte, die zwischen dem NMR-Rotor und der Bohrungswand bzw. zwischen dem NMR-Rotor und der Turbine wirken. Diese Reibungskräfte sind besonders dann zu berücksichtigen, wenn der Spalt zwischen NMR-Rotor und Bohrung sehr klein gewählt wird.

- Auftrieb, der vom Lift-Gasstrom erzeugt wird. Beim Ausbringen der Probe wird der Lift-Gasstrom so groß gewählt, dass der Auftrieb zu einer Aufwärtsbewegung der Probe führt, also Gewichtskraft, Reibungskraft und sonstige Kräfte überwindet. Beim Einbringen der Probe wird der Lift-Gasstrom so gewählt, dass die empfindliche Probe langsam ins Magnetzentrum gleitet und sanft auf der Turbine aufsetzt.

- Auftrieb, der vom Temperiergas verursacht wird. Der Temperier-Gasstrom muss so groß gewählt werden, dass der Temperaturgradient, der sich in der Probe einstellt, kleiner als der zulässige Maximalwert ist (dieser liegt für hochaufgelöste Messungen in der Größenordnung von 1 mK). Welcher Temperier-Gasstrom dafür nötig ist, hängt von der spezifischen Wärmekapazität des Temperiergases ab, sowie von der Größe der thermischen Störquellen. Typische Temperier-Gasströme liegen zwischen 400 l/h und 1000 l/h.

Der Lift-Gasstrom sollte unter keinen Umständen negativ werden. Dies wäre z.B. mit einer Pumpe möglich, die die Probe "nach unten saugt". Das hätte aber den Nachteil, dass in der Bohrung dann Unterdruck herrschen würde und Verunreinigungen (z.B. Staub) in den empfindlichsten Teil des NMR-Spektrometers gelangen würden.
Während der NMR-Messung ist der Lift-Gasstrom abgeschaltet.
Das Temperiergas kann während der NMR-Messung auf keinen Fall abgeschaltet werden, da sonst die Qualität der Messung massiv leiden würde. Während des Einbringens und Ausbringens der Probe kann der Temperier-Gasstrom theoretisch abgeschaltet werden. Dies ist jedoch nicht zu empfehlen, da sich dadurch die Temperatur einiger Komponenten in der Bohrung ändert. Wird die nächste NMR-Messung begonnen, müssen diese Komponenten zuerst wieder ihr thermisches Gleichgewicht erreichen, was lange dauern kann. Die Zeit, in der das Spektrometer genutzt werden kann, wird dadurch verringert. Es ist deshalb vorteilhaft, den Temperier-Gasstrom auch in den Perioden, in denen kein Experiment läuft, eingeschaltet zu lassen.
Weiter ist es vorteilhaft, den Temperier-Gasstrom von unten nach oben in vertikaler Richtung fließen zu lassen, da so Konvektion innerhalb des Gasstroms minimiert werden kann.

- Für NMR-Messungen an Flüssigproben - zumindest während des Shimmens, aber gelegentlich auch während des Experiments selbst - wird das Probenröhrchen mit der zu untersuchenden Flüssigkeit in Rotation um die z-Achse versetzt. Typische Drehzahlen bewegen sich zwischen 20 und 50 Umdrehungen pro Sekunde. Das Probenröhrchen wird dabei gemeinsam mit dem NMR-Rotor rotiert, in den es fest eingespannt ist. Diese Rotation zur Ausmittlung von Off-Axis Gradienten ist nicht zu verwechseln mit der oft angewandten, deutlich schnelleren Rotation von Festkörperproben um den sogenannten "Magic Angle", die mit einer Drehzahl von mehreren kHz stattfindet.

Es ergeben sich verschiedene Kräfte, die sich aus der Interaktion der Einheit aus NMR-Rotor und Probenröhrchen mit dem Magnetfeld resultieren. Besonders hervorzuheben sind:

○ Kräfte, die durch Wirbelströme entstehen. Wird eine Probe ins Magnetzentrum eingebracht, oder aus dem Magnetzentrum ausgeworfen, können sich im NMR-Rotor Wirbelströme ausbilden, sofern geschlossene, elektrisch leitende Strompfade existieren. Diese wirken dann wie eine "Wirbelstrombremse".

○ Kräfte, die sich durch Wechselwirkungen aus dem Material des Probenröhrchens, des NMR-Rotors und der Probensubstanz selbst ergeben. Ferromagnetische Werkstoffe finden in größeren Mengen oder Konzentrationen in der Herstellung von NMR-Rotoren oder Probenröhrchen üblicherweise keine Anwendung, da die Interaktion mit dem in NMR-Magneten typischerweise vorherrschenden sehr großen Magnetfelder viel zu groß wäre.

Üblicherweise werden vielmehr Materialien eingesetzt, die umgangssprachlich als "unmagnetisch" bezeichnet werden, genau genommen aber diamagnetisch oder paramagnetisch sind. Diamagnetische, paramagnetische, ferromagnetische und ferrimagnetische Materialien mit der Magnetisierung M und dem Volumen V erfahren in einem inhomogenen Magnetfeld mit Flussdichte B eine Kraft

$$F = (M*V)\nabla B.$$

Dabei werden nicht-diamagnetische Materialien in die Richtung gezogen, in der ein höheres Magnetfeld herrscht und diamagnetische Materialien in die Richtung, in der ein niedrigeres Magnetfeld herrscht. Die Magnetisierung M des Materials hängt vom anliegenden Flussdichte B und von der magnetischen Suszeptibilität $\chi$ *ab.*

$$M = (\chi/\mu_0)\ B$$

In diamagnetischen Materialien ist die Magnetisierung dem angelegten Feld entgegengerichtet, und für die magnetischen Suszeptibilität gilt $-1 < \chi < 0$, typischerweise $\chi = -10^{-6}...\ -10^{-9}$. Beispiele für diamagnetische Materialien sind $H_2O$ und Cu. Für nicht-diamagnetische Materialien gilt $\chi > 0$, typischerweise $\chi = 10^{-6}\ ...\ 10^{-2}$ für paramagnetische Materialien. Beispiele für paramagnetische Materialien sind $O_2$, Al oder Pt.

NMR-Rotoren sind üblicherweise aus Materialien wie POM oder PEEK gefertigt, die diamagnetisch sind. Oftmals wird in der Hochfeld-NMR mit wässrigen Probensubstanzen gearbeitet, die ebenfalls diamagnetisch sind.

Zum Vergleich, bei ferromagnetischen Materialien ist $\chi = 10^{+2}\ ...\ 10^{+5}$, die Wechselwirkung mit dem Magnetfeld ist also um ein Vielfaches größer als bei diamagnetischen oder paramagnetischen Materialien, weshalb ferromagnetische Materialien für den Bau von NMR-Rotoren üblicherweise keinen Einsatz finden.

Die beiden oben angegebenen Formeln zeigen, dass die Kraft, die auf die Einheit aus NMR-Rotor, Probenröhrchen und Probensubstanz wirkt, von den jeweiligen Materialeigenschaften und vom Produkt $B \cdot \nabla B$ abhängt.

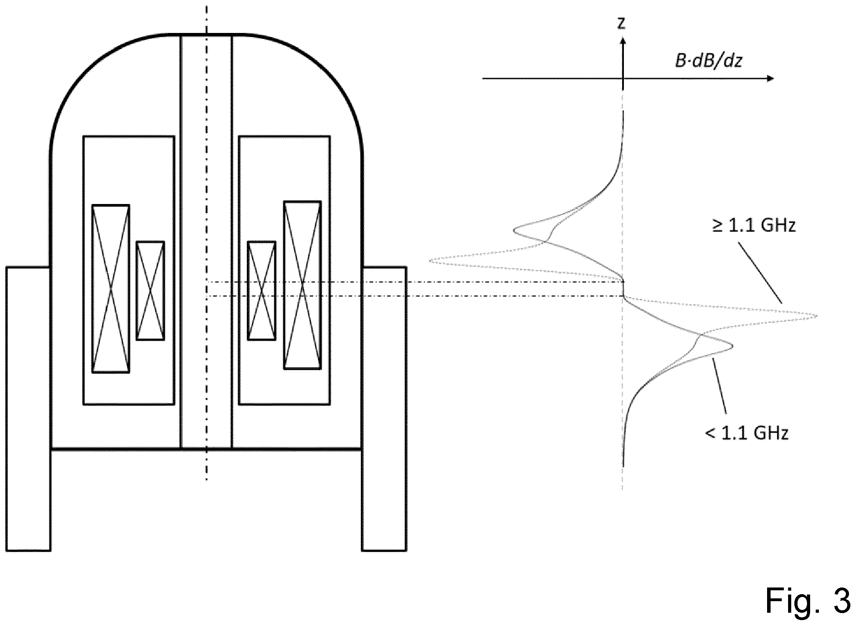

Die oben beschriebene herkömmliche Lösung weist den Nachteil auf, dass bei neuartigen Magneten -besonders bei Höchstfeldmagneten, bei denen im Magnet Insertspulen mit außerordentlich hohen Stromdichten (zum Beispiel aus HTS-Materialien) zum Einsatz kommen- entlang der z-Achse innerhalb der Bohrung das Produkt aus Magnetfeld mit Flussdichte B und Feldgradient dB/dz (also B * dB/dz) konstruktionsbedingt sehr hohe Werte erreichen kann. Dies tritt besonders im Randbereich der Insertspulen auf. Die kombinierte Abbildung in Fig. 3 zeigt beispielhaft die Verläufe von B*dB/dz für einen typischen Hochfeldmagnet < 1,1 GHz und für einen typischen Höchstfeldmagnet > 1,1 GHz entlang der z-Achse.

Aus den hohen Werten für B·dB/dz resultiert, dass die Kraft, die von den magnetischen Eigenschaften des NMR-Rotors herrührt, signifikant wird. Es ist technisch praktisch unmöglich, das Material des NMR-Rotors so zu definieren, dass dieser unter dem Einfluss hoher Magnetfelder und Feldgradienten magnetisch perfekt neutral (also gewissermaßen "unmagnetisch") ist.

Konkret führt dies dazu, dass sich in Extremfällen diamagnetische NMR-Rotoren gar nicht ins magnetische Zentrum des NMR-Spektrometers einbringen lassen und nicht-diamagnetische NMR-Rotoren sich nicht ohne einen sehr großen Lift-Gasstrom aus dem magnetischen Zentrum auswerfen lassen. Das Eigengewicht eines diamagnetischen NMR-Rotors reicht nicht mehr aus, um sicherzustellen, dass der NMR-Rotor ausreichend nach unten gedrückt wird, um unter dem Einfluss des Temperier-Gases nicht abzuheben. Nicht-diamagnetische NMR-Rotoren werden fest in Richtung des Magnetzentrums gedrückt, sodass der zum Auswurf ("Eject") benötigte Lift-Gasstrom in extremen Fällen zu groß werden könnte, oder - was deutlich öfter der Fall ist - die Reibungskräfte zwischen NMR-Rotor und Turbine bei der Probenrotation zu groß werden, und unter anderem zu Erwärmung führen.

Im Betriebszustand ist es vorteilhaft, wenn die magnetischen Kräfte dem Gewicht des NMR-Rotors nicht so stark entgegenwirken, dass sich dieser unter dem Einfluss des Temperier-Gases zu heben beginnt. Dies führt sonst zu Vibrationen (der NMR-Rotor hebt sich unter dem Einfluss des Gases aus seiner Ruheposition, dadurch kann mehr Gas unterhalb des NMR-Rotors durchströmen, der Druck sinkt, und der NMR-Rotor senkt sich wieder ab), die der Qualität der NMR Messung äußerst abträglich sind. In Extremfällen können die magnetischen Kräfte dem Gewicht des NMR Rotors so stark entgegenwirken, dass die Position des Rotors (und damit auch der NMR-Messprobe) gar nicht mehr ausreichend gut definiert ist.

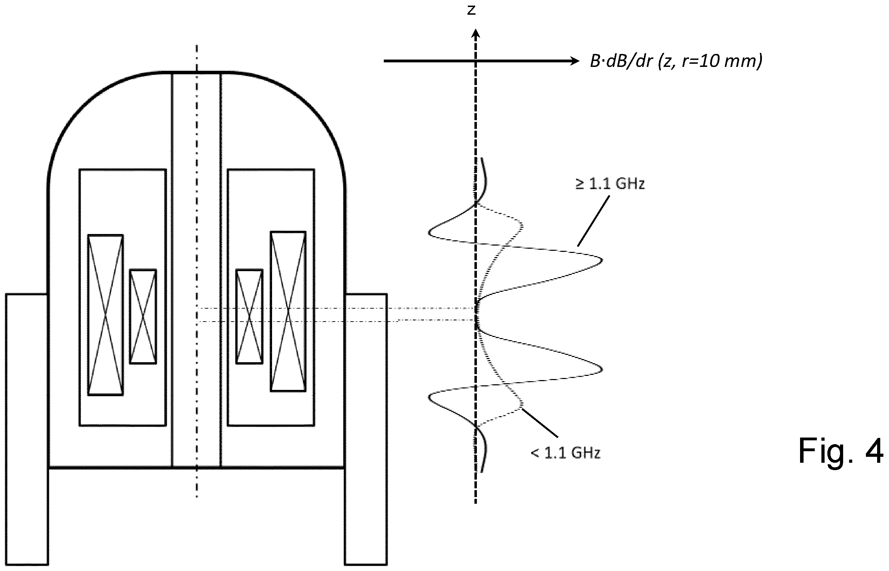

Des Weiteren ist es im Betriebszustand vorteilhaft, wenn der NMR-Rotor durch magnetische Kräfte radial zentriert wird (rücktreibende Kraft bei kleiner radialer Exzentrizität). In herkömmlichen Anordnungen (diamagnetischer NMR-Rotor in Magneten < 1,1 GHz) ist diese Forderung typischerweise erfüllt, weil das Kriterium B·dB/dr > 0 am Ort des NMR-Rotors eingehalten ist. In Magneten > 1,1GHz kann es dagegen einen Bereich mit umgekehrtem Vorzeichen von B·dB/dr geben, wo demnach ein überwiegend nicht-diamagnetischer NMR-Rotor vorteilhaft wäre. Abgesehen vom Vorzeichen von B·dB/dr am Ort des NMR-Rotors und vom Verhältnis von diamagnetischem zu nicht-diamagnetischem Volumenanteil und den Suszeptibilitäten der vorhandenen Materialien hängt die resultierende radiale Kraft auf den NMR-Rotor auch von der radialen Verteilung der Materialien im NMR-Rotor ab. Der typischer Verlauf von B·dB/dr entlang der z-Achse bei einem fixen Radius r = 10 mm ist beispielhaft in Fig. 4 gezeigt. Bei Höchstfeldmagneten kann B·dB/dr negative Werte annehmen.

Aufgabe der Erfindung

Der vorliegenden Erfindung liegt demgegenüber die Aufgabe zugrunde, einen NMR-Rotor der eingangs beschriebenen Art mit möglichst unaufwändigen technischen Mitteln dahingehend zu verbessern, dass die oben diskutierten Nachteile bekannter gattungsgemäßer Anordnungen vermieden werden. Insbesondere sollen mit der vorliegenden Erfindung NMR-Messungen an NMR-Proben bei besonders starken Magnetfeldern leichter durchzuführen sein, wobei die Qualität der NMR-Messung so hoch wie möglich und die Handhabung der NMR-Probe, vor allem deren Einbringen in den homogenen Bereich des Magnetfelds, möglichst einfach sein sollen.

Kurze Beschreibung der Erfindung

Diese -im Detail betrachtet relativ anspruchsvolle- Aufgabe wird durch die vorliegende Erfindung auf ebenso überraschend einfache und kostengünstige, aber sehr wirkungsvolle Weise dadurch gelöst, dass der NMR-Rotor aus mindestens zwei unterschiedlichen Materialien aufgebaut ist, von denen ein Material diamagnetische und ein anderes Material nicht-diamagnetische Eigenschaften aufweist, und dass die unterschiedlichen Materialien geometrisch derart im NMR-Rotor verteilt angeordnet sind, dass die magnetische Kraft auf den NMR-Rotor unter der Wirkung eines Produkts $\Phi_z$ aus magnetischer Flussdichte B und Flussdichtegradient dB/dz, dessen Betrag den Wert von 1400 T$^2$/m überschreitet, entweder in die gleiche Richtung wirkt wie die Gewichtskraft des NMR-Rotors, oder betragsmäßig kleiner ist als die Gewichtskraft des NMR-Rotors.

Die magnetische Kraft $F_{mag,z}$, welche im inhomogenen Bereich des NMR-Magnetfelds auf den erfindungsgemäßen NMR-Rotor einwirkt, genügt folgender Beziehung:

$$F_{mag,z} = \frac{1}{\mu_0} \cdot \int\limits_{V_{Rotor}} \chi \cdot B \cdot \frac{dB(z)}{dz} \cdot dV$$

wobei $\chi$ und B ortsabhängig sind. Dabei sind die Suszeptibilitäten $\chi$ von Material zu Material unterschiedlich.

Die geometrische Verteilung der Materialien im beziehungsweise am erfindungsgemäßen NMR-Rotor sollte derart gestaltet sein, dass es magnetische Eigenschaften aufweist, die im NMR-Messbetrieb unter Einfluss des NMR-Magnetfelds mit Flussdichte B und seiner inhomogenen Anteile dB/dz sicherstellen, dass die resultierende Magnetkraft auf die Einheit zwischen 0,02N und 0,2N, vorzugsweise mehr als 0,05 N, beträgt. Unter Berücksichtigung von gasdynamischen Kräften, die aufgrund einer Fluid-Turbine im Betrieb auf den NMR-Rotor einwirken können, wird es in manchen Anwendungsfällen erforderlich sein, eine am Rotor angreifende Gesamtkraft von mehr als 0,2N zu kompensieren.

Vorzugsweise wird die Art der unterschiedlichen Materialien so ausgewählt und die Materialien derart im Rotor angeordnet sein, dass sich unter Einfluss des NMR-Magnetfelds mit Flussdichte B und seiner inhomogenen Anteile dB/dz keine mechanischen Momente und keine Unwucht bei Rotation im NMR-Messbetrieb auf die Einheit aus Rotor, Probenbehälter und Probensubstanz ergeben. Zudem sollte der NMR-Rotor so gestaltet sein, dass er in einem NMR-Magneten mit gegebenem Verlauf des NMR-Magnetfelds B und dessen inhomogener Anteile dB/dz unter Einfluss des magnetischen Felds im Betrieb und bei Rotation des Rotors radial selbstzentrierend ist.

Wie erwähnt wird der NMR-Rotor aus mindestens zwei unterschiedlichen Materialien gefertigt, von denen eines diamagnetische und ein anderes nicht-diamagnetische -also normalerweise paramagnetische, ferromagnetische oder ferrimagnetische- Eigenschaften besitzt. Damit wird insbesondere auch die Handhabung der NMR-Probe, vor allem deren Einbringen in den homogenen Bereich des Magnetfelds, erheblich vereinfacht.

Beim Einbringen und Auswerfen des NMR-Rotors in bzw. aus dem NMR-Magneten wird mit dem Rotor die ganze Magnet-Bohrung oder jedenfalls fast deren gesamte Länge durchfahren. Daher sollte der erfindungsgemäße NMR-Rotor auf alle Bereiche von jeweils angreifenden Magnetkräften ausgelegt werden.

Die Forderung, dass die magnetische Kraft auf den NMR-Rotor unter der Wirkung eines Produkts $\Phi_z$ aus magnetischer Flussdichte B und Flussdichtegradient dB/dz, dessen Betrag den Wert von 1400 T$^2$/m überschreitet, entweder in die gleiche Richtung wirkt wie die Gewichtskraft des NMR-Rotors, oder betragsmäßig kleiner ist als die Gewichtskraft des NMR-Rotors, stellt sicher, dass der NMR-Rotor auch sicher in den homogenen Bereich des Magnetfelds gelangt und beim Einbringen nicht außerhalb des homogenen Bereichs "hängenbleibt".

In der Regel wird das Auswerfen eines NMR-Rotors samt Probenbehälter und Probensubstanz in einem NMR-System mittels Druckluft erfolgen, die von unten eingeblasen wird. Dabei wird davon ausgegangen, dass der Magnet des NMR-Spektrometers, in welchem der erfindungsgemäße NMR-Rotor eingesetzt werden soll, eine vertikale Bohrung aufweist, bei welcher die Bohrungsachse im Wesentlichen parallel zum vertikalen Gravitationsvektor verläuft.

Mit einem "brute-force" Ansatz-also mit ausreichend hohem Druck bzw. einer ausreichend hohen Gasflussrate- bekäme man daher wohl auch einen nicht optimal ausgelegten Rotor wieder aus der Bohrung, der vom Magnet in Richtung Magnetzentrum gezogen wird.

Dies sollte aber durch geeignete Dimensionierung der unterschiedlichen magnetischen Materialien des erfindungsgemäßen NMR-Rotors tunlichst vermieden werden, indem der NMR-Rotor so ausgelegt wird, dass die magnetische Kraft auf den NMR-Rotor vorzugsweise kleiner als 50% der Gewichtskraft des NMR-Rotors ist.

Bevorzugte Ausführungsformen und Weiterbildungen der Erfindung

Ganz besonders bevorzugt ist eine Klasse von Ausführungsformen des erfindungsgemäßen NMR-Rotors, bei denen das Produkt $\Phi_z$ gegeben ist durch

$$\Phi_z = \frac{1}{V_{Rotor}} \cdot \int_{V_{Rotor}} B \cdot \frac{dB(z)}{dz} \cdot dV$$

wobei gilt: $|\Phi_z| > 1400$ T$^2$/m, bevorzugt $|\Phi_z| > 1500$ T$^2$/m, besonders bevorzugt $|\Phi_z| > 2000$ T$^2$/m, und wobei

$V_{Rotor}$ das Volumen des NMR-Rotors und

dV ein infinitesimales Volumenelement des NMR-Rotors

bedeuten.

NMR-Rotoren, die mit solch hohen Werten von $\Phi_z$ kompatibel sind, eignen sich für den Einsatz in der leistungsfähigsten und modernsten Klasse von NMR Magneten, die sich aufgrund der in ihrem Zentrum herrschenden hohen Flussdichte von mehr als 23 T, manchmal mehr als 25 T und gelegentlich sogar mehr als 28 T auszeichnen. Diese hohen Flussdichten machen NMR Messungen mit besonders hoher Auflösung und besonders hohem Signal-zu-Rauschverhältnis möglich. Aus praktischen Gründen (Laborgröße, Transport) müssen diese höchst leistungsfähigen Magnete auch so kompakt wie möglich sein. Dies führt wiederum zu steilen (großen) Feldgradienten dB/dz entlang der Bohrung, was zusätzlich zu einem großen Produkt $\Phi_z$ beiträgt. Durch die Kompatibilität mit solch hohen Werten von $\Phi_z$ ermöglichen die hier beschriebenen NMR-Rotoren Messungen in dieser Klasse von NMR Magneten.

Eine besonders vorteilhafte weitere Klasse von Ausführungsformen des erfindungsgemäß gestalteten NMR-Rotors zeichnet sich dadurch aus, dass mindestens ein nicht-diamagnetisches Material des NMR-Rotors, vorzugsweise *sämtliche nicht-diamagnetischen Materialien*, paramagnetische Eigenschaften aufweisen.

Paramagnetische Materialien sind - da sie in inhomogenen Feldern in Richtung des höheren Magnetfelds gezogen werden - ideal geeignet, um die Kraft in Richtung des niedrigeren Magnetfelds, die auf ein diamagnetisches Grundmaterial wirkt, auszugleichen.

Ferromagnetische und ferrimagnetische Materialien werden in inhomogenen Feldern ebenfalls in Richtung des höheren Felds gezogen, allerdings sind ihre Suszeptibilitäten mit $\chi = 10^{+2} ... 10^{+5}$ derart hoch, dass es - aufgrund mechanischer Fertigungstoleranzen und Ungenauigkeiten in der Bestimmung der Menge - deutlich schwieriger wäre, eine genaue Kompensation eines diamagnetischen Materials zu erreichen. Paramagentische Materialien haben typischerweise eine magnetische Suszeptibilität von $\chi = 10^{-6} ... 10^{-2}$, also vier bis elf Größenordnungen kleiner als die von ferromagnetischen oder ferrimagnetischen Materialien. Eine gewünschte Kraftwirkung lässt sich also deutlich genauer einstellen als mit ferro- oder ferrimagnetischen Materialen. Bei bevorzugten Weiterbildungen dieser weiteren Klasse von Ausführungsformen sind mindestens ein diamagnetisches und mindestens ein nicht-diamagnetisches Material im NMR-Rotor derart angeordnet, dass im NMR-Magnetfeld mit Flussdichte B eines Hochfeld-NMR-Magneten am Ort des NMR-Rotors gilt:

$$\chi_{dia} \cdot \int_{V_{dia}} \frac{dB}{dr} \cdot dV + \chi_{non-dia} \cdot \int_{V_{non-dia}} \frac{dB}{dr} \cdot dV < 0$$

wobei

$\chi_{dia}$ die magnetischen Suszeptibilität des diamagnetischen Materials, $\chi_{non-dia}$ die magnetischen Suszeptibilität des nicht-diamagnetischen Materials, $V_{dia}$ das Volumen des diamagnetischen Materials im NMR-Rotor,

$V_{non-dia}$ das Volumen des nicht-diamagnetischen Materials im NMR-Rotor, dB/dr den Gradienten der Flussdichte des NMR-Magnetfeldes im Volumen des Rotors in radialer Richtung bezüglich der z-Achse und

dV ein infinitesimales Volumenelement des NMR-Rotors

bedeuten.

Ein solcher NMR-Rotor hat den Vorteil, dass er sich im inhomogenen Feld eines Hochfeldmagnets, das aufgrund der extrem hohen Stromdichte in den Insertspulen in radialer Richtung negative Gradienten B·dB/dr aufweisen kann, selbst zentriert. Diese Selbstzentrierung hilft dabei, dass der Probenbehälter mit der zu untersuchenden Probensubstanz quasi von selbst in den Zentralbereich gelangt, wo das Magnetfeld am homogensten und für eine hochwertige NMR Messung am geeignetsten ist. Wird der NMR-Rotor zur Ausmittlung von Off-Axis Gradienten im Bereich des Probenbehälters um die z-Achse rotiert, hilft die magnetische Selbstzentrierung, um einen fast perfekten Rundlauf zu garantieren.

Vorteilhaft sind auch Ausführungsformen der Erfindung, bei denen mindestens eines der Materialien des NMR-Rotors, insbesondere das paramagnetische, falls es elektrisch leitfähig ist, im NMR-Rotor derart angeordnet ist, dass es die Aufnahme nicht vollständig umschließt. Damit sollen insbesondere Kreisströme verhindert werden.

Beim Ein- und Ausbringen des NMR-Rotors ins oder aus dem homogenen Bereich des Magnetfelds würden sich sonst Kreisströme im elektrisch leitenden Material ausbilden, die zur Erwärmung des Rotors führen. Diese Erwärmung kann so stark sein, dass sich die Temperatur der zu messenden Probensubstanz erhöht. Bei empfindlichen Substanzen - z.B. biologischen Proben - kann dies sogar zur Zerstörung der Substanz führen.

Außerdem wirken die Kreisströme -durch ihre Interaktion mit dem Magnetfeldwie eine Wirbelstrombremse, d.h. der Rotor scheint sich der gewünschten Bewegungsrichtung (typischerweise nach unten beim «Inject», und nach oben beim «Eject») zu widersetzen. Dies kann dazu führen, dass der Inject, wenn er nur durch Gravitation getrieben wird, sehr langsam von statten geht, und für den Eject hohe Gasflüsse und/oder Drücke benötigt werden.

Weitere vorteilhafte Ausführungsformen der Erfindung zeichnen sich dadurch aus, dass der NMR-Rotor eine Rotor-Achse im Zentrum der Aufnahme umfasst, die beim Einbringen des Probenbehälters in den homogenen Bereich des Magnetfelds entlang der z-Achse orientiert ist, dass der NMR-Rotor spiegelsymmetrisch bezüglich einer die Rotor-Achse enthaltenden Symmetrie-Ebene und/oder rotationssymmetrisch bezüglich der Rotor-Achse, aufgebaut ist, und dass das diamagnetische Material und das nicht-diamagnetische Material spiegelsymmetrisch und/oder rotationssymmetrisch um die Rotor-Achse im NMR-Rotor verteilt ist.

Beispielsweise kann der NMR-Rotor eine um die Rotor-Achse zylinderförmige Aufnahme umfassen. Die Querschnitte des Rotors senkrecht zur Zylinderachse werden in der Regel Kreise sein, so dass die Aufnahme kreiszylindrische Symmetrie aufweist und daher besonders einfach herstellbar ist. Für Spezialanwendungen sind aber auch andere Formen der Zylinderquerschnitte denkbar, etwa Ellipsen. Außerdem könnte eine es auch eine mehrzählige Symmetrie des erfindungsgemäßen NMR-Rotors geben, so dass zum Beispiel an seinem äußeren Rand eine Riffelung für einen Fluid-Antrieb der Rotation vorhanden ist.

Für manche Anwendungen werden auch Probenbehälter verwendet, in denen das Flüssigkeitsvolumen, in dem sich die zu untersuchende Substanz während der Messung befindet, beispielsweise einen rechteckförmigen oder elliptischen Querschnitt aufweisen. Diese -üblicherweise «slotted tubes» genannten Probenbehälter- ermöglichen unter speziellen Bedingungen höhere Signal-zu-Rausch-Verhältnisse. NMR-Rotoren für solche Röhrchen könnten in einigen Fällen nur einfach spiegelsymmetrisch sein.

Spiegelsymmetrische Anordnungen sind außerdem ideal geeignet, um elektrisch leitende Materialen so anzuordnen, dass sich keine Kreisströme ausbilden können, während gleichzeitig sichergestellt ist, dass der Rotor keine Unwucht aufweist, die die Rotation um die z-Achse beeinträchtigen könnte.

Bei bevorzugten und in der individuellen Ausgestaltung besonders flexiblen Weiterbildungen dieser Ausführungsformen ist eines der Materialien des NMR-Rotors, bevorzugt ein nicht-diamagnetisches, besonders bevorzugt ein paramagnetisches Material, in Form von mindestens zwei stabförmigen Teilen ausgebildet und im Grundmaterial des NMR-Rotors in parallel zur Rotor-Achse verlaufenden Parallelbohrungen angeordnet. Die Parallelbohrungen und die stabförmigen Teile sollten möglichst symmetrisch um die Rotor-Achse verteilt sein. Denkbar sind auch Varianten, bei welchen mehr Bohrungen vorhanden sind, als dann im konkreten NMR-Experiment stabförmige Teile in den Rotor eingesetzt werden. Man könnte beispielsweise 12 Bohrungen vorsehen und dann im Einzelfall nur 6 mit einem paramagnetischen bzw. nicht-diamagnetischen Material beschicken. Auf diese Weise können die magnetischen Eigenschaften des Rotors sehr individuell auf die tatsächlich vorgefundenen und sich womöglich auch ändernden Verhältnisse vor Ort optimal angepasst werden.

Die oben beschriebene Ausbildungsform mit stabförmigem Kompensationsmaterial ist besonders einfach und kostengünstig zu fertigen. Diese Ausbildungsform ist außerdem ideal geeignet, um elektrisch leitende Materialen so anzuordnen, dass sich keine Kreisströme ausbilden können, während gleichzeitig sichergestellt ist, dass der Rotor keine Unwucht aufweist, die die Rotation um die z-Achse beeinträchtigen könnte.

Alternativ kann bei weiteren vorteilhaften Weiterbildungen das nicht-diamagnetische und das diamagnetische Material des NMR-Rotors zumindest teilweise, vorzugsweise homogen, gemischt sein, insbesondere Partikel in Kunststoff, bevorzugt paramagnetische Partikel in einem diamagnetischen Kunststoff. Diese Varianten der Erfindung lassen sich besonders einfach und preisgünstig - z.B. durch herkömmliche Spritzgussverfahren - herstellen.

Vorteilhaft ist, dass einfach und kostengünstig eine große Anzahl «Kompensationspartikel» gleichmäßig verteilt werden kann. Auf makroskopischer Ebene scheint das Rotormaterial also tatsächlich magnetisch komplett neutral zu sein und gleichzeitig eine homogene Dichte zu haben, was in Bezug auf Unwucht und auf die magnetischen Eigenschaften vorteilhaft ist.

Bei anderen alternativen Weiterbildungen werden die Materialien des NMR-Rotors mit unterschiedlichen magnetischen Eigenschaften zumindest teilweise in einer oder mehreren Schichten aufgetragen. Auch diese Herstellungsweise ist technisch gut beherrschbar und führt zu sehr präzisen Ergebnissen.

Besonders bevorzugt sind auch Ausführungsformen des erfindungsgemäßen NMR-Rotors, bei welchen der NMR-Rotor *überwiegend aus einem* der mindestens zwei Materialien mit unterschiedlichen magnetischen Eigenschaften aufgebaut ist, vorzugsweise aus einem diamagnetischen Material. Diese Ausführungsformen werden vermutlich für normale Laboranwendungen die Regel darstellen.

Üblicherweise wird der Rotor aus einem Grundmaterial gefertigt, und dann wird auf eine der oben beschriebenen Weisen Kompensationsmaterial ein- oder aufgebracht. Es ist auch möglich, herkömmliche Rotoren für Niederfeldmagnete nachträglich -z.B. durch Einbringen von Kompensationsstäben in dafür vorgesehene Bohrungen oder durch Aufbringen von Kompensationsschichten - für den Einsatz in Höchstfeldmagneten umzurüsten. Typische Materialien, die sich für die Fertigung der Grundkörper eigenen, sind wie eingangs erwähnt POM, PEEK oder PCTFE, also diamagnetische Materialien.

In der Praxis als besonders vorteilhaft erweisen sich Weiterbildungen dieser Ausführungsformen, bei denen der NMR-Rotor zu einem Anteil zwischen 90 und 95 Volumen%, vorzugsweise zu etwa 92,5 Volumen%, aus dem einen der mindestens zwei Materialien mit unterschiedlichen magnetischen Eigenschaften aufgebaut ist und zu einem Anteil von 5 bis 10 Volumen%, vorzugsweise zu etwa 7,5 Volumen%, aus dem anderen Material. Dabei ist zu beachten, dass die Volumenprozente von den Suszeptibilitäten der konkret verwendeten Materialien abhängen. Die oben angegebenen Werte ergeben sich aus den Suszeptibilitäten der gängigsten dia- und paramagnetischen Materialen. Es ist vorteilhaft, die Suszeptibilitäten so zu wählen, dass von jedem der eingesetzten Materialien eine Menge verbaut werden muss, die groß genug ist, dass Mengenschwankungen, die sich aus Fertigungstoleranzen ergeben, klein sind im Vergleich zur ihrer Absolut-Menge.

Ganz besonders bevorzugt ist eine Klasse von Ausführungsformen der Erfindung, bei welchen das diamagnetische Material Kunststoff, beispielsweise POM, PEEK oder PCTFE, und/oder keramischen Werkstoff wie Glaskeramik, insbesondere mit in einer Borosilikat-Matrix eingelagertem Glimmer, oder eine bearbeitbare Aluminiumnitrid-Keramik enthält. POM, PEEK oder PCTFE zeichnen sich durch ihre gute Bearbeitbarkeit, ihre mechanischen Eigenschaften und ihre Widerstandsfähigkeit gegen viele Chemikalien aus. Keramische Werkstoffe zeichnen sich insbesondere durch ihre hohe Temperaturbeständigkeit aus, was NMR-Messungen im Hochtemperaturbereich ermöglicht.

Bei weiteren bevorzugten Varianten oben beschriebener Ausführungsformen des erfindungsgemäßen NMR-Rotors enthält das nicht-diamagnetische, insbesondere das paramagnetische Material, Titan, Aluminium oder Platin. Diese Materialien können leicht in guter Qualität und hoher Reinheit beschafft werden. Halbzeuge sind in einer Vielzahl von Formen erhältlich, was die Fertigung schnell und kostengünstig macht.

Ergänzend oder alternativ kann bei weiteren Ausführungsformen des erfindungsgemäß ausgestalteten NMR-Rotors die geometrische Verteilung der Materialien im beziehungsweise am NMR-Rotor derart gestaltet sein, dass die magnetische Kraft auf den NMR-Rotor zwischen 0,02N und 0,2N, vorzugsweise höchstens 0,05N, beträgt.

Diese Kraftgrenzen haben sich im praktischen Betrieb besonders bewährt, und führen in einer Vielzahl praktisch auftretender experimenteller Bedingungen (z.B. unterschiedliche Temperiergas-Ströme zwischen 400 l/h und 1000 l/h, Probenrotation zwischen 5 und 50 Hz und in NMR Magneten bis zu einer 1H Resonanzfrequenz von 1.2 GHz) zu guten Ergebnissen, in denen der Rotor mit Probe zum einen problemlos in den homogenen Bereich des Magnetfelds eingebracht und auch wieder ausgeworfen werden kann, und zum anderen während der Messung ruhig und vibrationsfrei auf der Turbine sitzt.

In den Rahmen der vorliegenden Erfindung fällt auch ein Verfahren zur Auslegung und Herstellung eines erfindungsgemäßen NMR-Rotors Apparatur der oben beschriebenen Art, welches dadurch gekennzeichnet ist, dass zunächst die magnetische Suszeptibilität eines Grundmaterials des Rotors, vorzugsweise des diamagnetischen Materials, bestimmt wird, und dass anschließend eine magnetische Kompensation des NMR-Rotors durch ein weiteres Material mit unterschiedlichen magnetischen Eigenschaften, vorzugsweise paramagnetisches Material, in Abhängigkeit des Messergebnisses des Grundmaterials für jeden NMR-Rotor individuell, insbesondere unter Berücksichtigung der speziellen Eigenschaften des verwendeten Hochfeld-NMR-Magneten, bestimmt wird. Vorzugsweise wird für jede Klasse von Probensubstanzen abhängig von deren Suszeptibilität sowie derjenigen des Lösungsmittels (in der Regel wässrige Lösungen, Aceton, etc.) ein spezieller NMR-Rotor hergestellt.

Dieses Verfahren ermöglicht eine annähernd perfekte Abstimmung der magnetischen Eigenschaften auf die jeweils vorherrschenden Bedingungen, und ermöglicht so - ohne übermäßigen Aufwand - bestmögliche Ergebnisse aus einem NMR Höchstfeldspektrometer herauszuholen. Gemessen an den Gesamtkosten eines NMR Höchstfeldspektrometers verursacht das oben beschriebene Verfahren vernachlässigbare Zusatzkosten, trägt jedoch entscheidend zur Qualität der NMR-Messung bei.

Detaillierte Beschreibung der Erfindung und Zeichnung

Die Erfindung ist in der Zeichnung dargestellt und wird anhand von Ausführungsbeispielen näher erläutert.

Es zeigen:

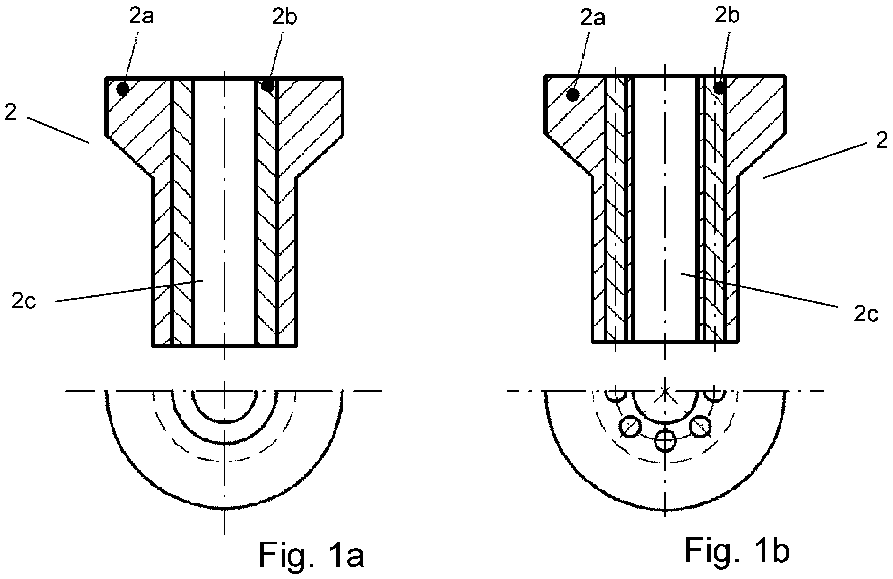

Fig. 1a     eine schematische Vertikalschnittansicht einer ersten Ausführungsform des erfindungsgemäßen NMR-Rotors mit einem Mantelteil aus diamagnetischem Material und einem zylindrischen Einsatz aus nicht-diamagnetischem Material, wobei im unteren Bereich der Figur ein schematischer Halbschnitt durch eine Ebene senkrecht zur Achse dargestellt ist;

Fig. 1b     ähnlich wie Fig. 1a, aber mit einer zweiten Ausführungsform des erfindungsgemäßen NMR-Rotors, bei der in einem Mantelteil aus diamagnetischem Material parallel zur Achse verlaufende Bohrungen zum Einsetzen von Stäben aus nicht-diamagnetischem Material vorgesehen sind;

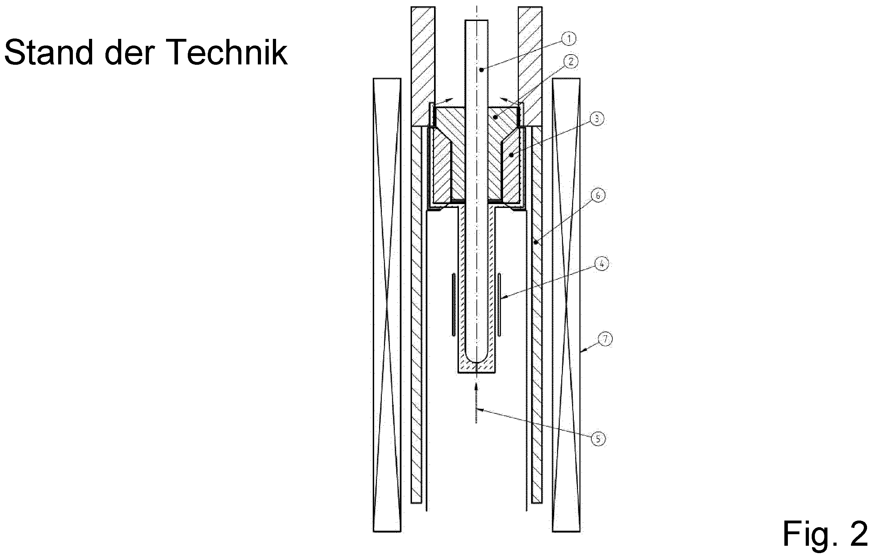

Fig. 2     einen schematischen Vertikalschnitt durch einen Ausschnitt eines NMR-Spektrometers nach dem Stand der Technik mit einem NMR-Probenkopf, der einen Probenhalter mit NMR-Rotor und eingesetztem Probenröhrchen in Messposition trägt;

Fig. 3     einen schematischen Vertikalschnitt durch ein NMR-Spektrometer -der Übersichtlichkeit halber ohne Probenkopf- sowie rechts daneben in z-Richtung den typischen Verlauf des Produkts $\Phi_z$ aus magnetischer Flussdichte B und Flussdichtegradient dB/dz für ein Magnetsystem mit einer Feldstärke < 1,1 GHz (durchgezogene Linie) sowie für einen Höchstfeld-Magneten mit einer Feldstärke $\geq$ 1,1GHz (gepunktete Linie); und

Fig. 4     einen typischen Verlauf des Produkts $\Phi_r$ aus magnetischer Flussdichte B und Flussdichtegradient dB/dr in radialer Richtung (senkrecht zur z-Achse) beim Radius r = 10 mm für ein Magnetsystem mit einer Feldstärke < 1,1 GHz (gepunktete Linie) sowie für einen Höchstfeld-Magneten mit einer Feldstärke $\geq$ 1,1GHz (durchgezogene Linie).

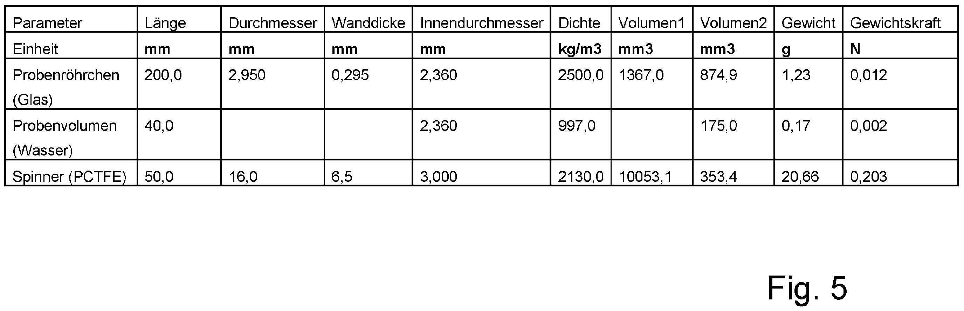

Fig. 5     eine Tabelle mit konkreten Zahlenwerten für ein typisches Ausführungsbeispiel eines NMR-Rotors.

Die Figuren 1a und 1b der Zeichnung zeigen jeweils in schematischen Ansichten bevorzugte Ausführungsformen des erfindungsgemäßen NMR-Rotors, wie er mit diesen Modifikationen auch in dem in **Fig. 2** ausschnittsweise gezeigten NMR-Spektrometer nach dem Stand der Technik eingebracht werden kann.

Ein derartiges NMR-System, in der Regel ein NMR-Spektrometer, mit einem **NMR-Magnetsystem 7** zur Erzeugung eines homogenen statischen Magnetfelds mit Flussdichte B entlang einer **z-Achse 5** umfasst im Messbetrieb einen **Probenkopf 6**, der ein **HF-Sende- und Empfangs-Spulensystem 4** aufweist sowie eine in z-Richtung verlaufende Öffnung zur Aufnahme eines **NMR-Probenbehälters 1** (in der Regel in Form eines Probenröhrchens), der im Betrieb eine mittels NMR-Messung zu untersuchende Probensubstanz enthält. Der NMR-Probenbehälter 1 mit -in der Zeichnung der Übersichtlichkeit halber nicht eigens dargestellter- Probensubstanz wird von einem Probenbehälter mit **NMR-Rotor 2** (="Spinner") gehalten, zur NMR-Messung gemeinsam mit einem Probenhalter in den NMR-Probenkopf 6 eingebracht (="inject") und nach der Messung auch gemeinsam wieder ausgeworfen (="eject"). Beim Einbringen des Probenhalters in den homogenen Bereich des Magnetfelds durchläuft dieser Bereiche mit inhomogenen Magnetfeldanteilen und zumindest einem Flussdichtegradienten dB/dz. Im NMR-Messbetrieb lagert der -in der Regel rotierbare- NMR-Rotor 2 auf einem **NMR-Stator 3** ("Turbine") beziehungsweise auf einem vom NMR-Stator 3 oder einer Drucklufteinrichtung erzeugten Luftstrom, wobei sich zumindest der Teil der Probensubstanz, an welchem die NMR-Messung vorgenommen werden soll, im homogenen Bereich des Magnetfelds befindet.

Der **erfindungsgemäße NMR-Rotor 2** zeichnet sich gegenüber den bekannten NMR-Rotoren nach dem Stand der Technik dadurch aus, dass er aus mindestens zwei unterschiedlichen Materialien aufgebaut ist, von denen ein Material diamagnetische und ein anderes Material nicht-diamagnetische, vorzugsweise paramagnetische, Eigenschaften aufweist. Die unterschiedlichen Materialien sind erfindungsgemäß geometrisch derart im NMR-Rotor 2 verteilt angeordnet, dass die magnetische Kraft auf den NMR-Rotor 2 unter der Wirkung eines Produkts $\Phi_z$ aus magnetischer Flussdichte B und Flussdichtegradient dB/dz, dessen Betrag den Wert von 1400 T$^2$/m überschreitet, entweder in die gleiche Richtung wirkt wie die Gewichtskraft des NMR-Rotors 2, oder betragsmäßig kleiner ist als die Gewichtskraft des NMR-Rotors 2.

In **Fig. 1a** ist eine besonders einfach herzustellende Ausführungsform des erfindungsgemäßen NMR-Rotors 2 abgebildet. Letzterer umfasst ein **Mantelteil 2a aus diamagnetischem Material** sowie einen -im vorliegenden Ausführungsbeispiel zylinderförmigen- **Einsatz 2b aus nicht-diamagnetischem Material.** In dieser Ausführungsform umfasst der Einsatz 2b die **Aufnahme 2c für einen Probenbehälter.**

Eine weitere, bevorzugte Ausführungsform des erfindungsgemäßen NMR-Rotors 2 ist in **Fig. 1b** dargestellt. Hier sind in einem Mantelteil 2a aus diamagnetischem Material parallel zur Rotorachse (und mithin im Messbetrieb parallel zur z-Achse) verlaufende Bohrungen zum Einsetzen von stabförmigen Einsätzen 2b aus nicht-diamagnetischem Material vorgesehen. Bei dieser Ausführungsform kann das nicht-diamagnetische Material der stabförmigen Einsätze 2b auch elektrisch leitfähig sein, da dieses Material im NMR-Rotor 2 derart angeordnet ist, dass es die Aufnahme für das Probenröhrchen nicht vollständig umschließt, so dass kein Wirbelstrom in der Ebene senkrecht zur z-Achse fließen kann.

**Fig. 3** zeigt auf der linken Seite einen Vertikalschnitt durch ein NMR-Spektrometer. Rechts daneben ist der typische Verlauf in z-Richtung des Produkts $\Phi_z$ aus magnetischer Flussdichte B und Flussdichtegradient dB/dz dargestellt, und zwar einerseits für ein Magnetsystem mit einer Feldstärke < 1,1 GHz (durchgezogene Linie), andererseits für einen Höchstfeld-Magneten mit einer Feldstärke $\geq$ 1,1 GHz (gepunktete Linie). Damit lässt sich der jeweiligen z-Position im Spektrometer der jeweils zugehörige $\Phi_z$-Wert zuordnen.

Während der NMR-Messung befindet sich der zu vermessende Teil der Probensubstanz im -hier aus Übersichtlichkeitsgründen nicht eigens dargestellten- Probenröhrchen in einem Messvolumen der NMR-Anordnung. Dieses entspricht dem -naturgemäß relativ kurzen- z-Abschnitt mit flach auf der z-Achse verlaufendem Produkt $\Phi_z$ = B·dB/dz, also dem homogenen Magnetfeldbereich, in welchem die NMR-Messung stattfindet. Darüber (und natürlich auch darunter) weist das Produkt $\Phi_z$ einen Verlauf mit ganz erheblich höheren Werten auf. Durch diesen inhomogenen Feldbereich mit auf den NMR-Rotor wirkenden teilweise sehr hohen Magnetkräften muss aber vor der Messung der Probenhalter mit Messprobe eingebracht und nach der Messung wieder ausgeworfen werden. Auch während der eigentlichen Messung befindet sich der NMR-Rotor zumindest teilweise im inhomogenen Feldbereich.

**Fig. 4** zeigt in z-Richtung im Abstand von 10 mm von der z-Achse einen typischen Verlauf des Produkts $\Phi r$ aus magnetischer Flussdichte B und Flussdichtegradient dB/dr in radialer Richtung senkrecht zur z-Achse für ein Magnetsystem mit einer Feldstärke < 1,1 GHz (gepunktete Linie) sowie für einen Höchstfeld-Magneten mit einer Feldstärke $\geq$ 1,1 GHz (durchgezogene Linie).

Man erkennt, dass es bei Magneten > 1,1 GHz einen Bereich mit umgekehrtem Vorzeichen von B·dB/dr geben kann. Wird in diesem Bereich paramagnetisches Rotormaterial eingesetzt, erfährt dieses Material eine selbstzentrierende Kraft. Abgesehen vom Vorzeichen von B·dB/dr am Ort des NMR-Rotors und vom Verhältnis von diamagnetischem zu paramagnetischem Volumenanteil und den Suszeptibilitäten der vorhandenen Materialien hängt die resultierende radiale Kraft auf den NMR-Rotor auch von der radialen Verteilung der Materialien im NMR-Rotor ab.

Bei einem schichtförmigen Aufbau des erfindungsgemäßen NMR-Rotors lassen sich zu den zu erwartenden Schichtdicken folgende konkrete Zahlenbeispiele angeben:

- Wenn man wir davon ausgeht, dass der NMR-Rotor ein Volumen von 10cm$^3$ hat, entspräche das in etwa einem Zylinder mit einer Länge von 50mm, einem Außendurchmesser von 16mm, und einer Zentralbohrung (für das NMR-Probenröhrchen) von 3mm.
- Wenn 0,77cm$^3$ davon aus paramagnetischen Material sein sollen, würde das bedeuten, dass die äußersten 0,6mm aus paramagnetischem Material sein müssten. Man hätte also einen diamagnetischen Zylinder mit einer 3mm-Bohrung und einem Außendurchmesser von 15,4mm. Darauf wäre dann (etwa in einem Ausführungsform gemäß Fig. 1a) eine Schicht mit einer Dicke von 0,6mm aus paramagnetischem Material angebracht.

Falls man sich für eine Ausführungsform mit Stäben (etwa gemäß Fig. 1b) entscheidet und beispielsweise acht Stäbe vorsieht, müsste jeder ein Volumen von 0,09625cm$^3$ haben. Bei einer Stablänge von 5cm entspricht das einem Durchmesser von etwa 1,55mm pro Stab.

Bedeutsam für den erfindungsgemäßen NMR-Rotor ist die Tatsache, dass er in einem Produkt $\Phi_z$ = B·dB/dz eine magnetische Kraft erfährt, deren Betrag - falls sie entgegen der Gewichtskraft gerichtet ist - geringer als seine Gewichtskraft ist. Probenbehälter und Probensubstanz können bei dieser Betrachtung vernachlässigt werden.

Die Tabelle in **Fig. 5** zeigt typische Zahlenwerte der Gewichtskraft eines Probenbehälters (=Probenröhrchen), einer Probensubstanz (hier: Wasser) und eines Spinners (hier aus PCTFE). Volumen1 und Volumen2 dienen der Berechnung des effektiven Volumens des hohlzylinderförmigen Probenröhrchens und Spinners. Es wird aus der Berechnung klar, dass der Spinner den signifikanten Beitrag zur Gewichtskraft ausmacht.

In guter Näherung ist der Magnetfeldgradient über dem Volumen des NMR-Rotors konstant. Das Erfordernis der richtigen geometrischen Anordnung erwächst daraus, dass das Produkt $\phi_z$ = B·dB/dz dennoch stark variiert und die beiden Enden des NMR- Rotors jeweils stark unterschiedlichen magnetischen Kräften ausgesetzt sind.

In der Praxis ist es für den Anwender günstig, wenn mehrere unterschiedliche NMR-Rotoren, etwa mit unterschiedlicher Verteilung der diamagnetischen und nicht-diamagnetischen Materialien, (in der Regel zusammen mit einem NMR-Spektrometer) ausgeliefert werden. Der Benutzer des Spektrometers kann dann für jede Probensubstanz (z.B. wässrige Lösung / nicht-wässrige Lösung) einen besonders geeigneten NMR-Rotor auswählen.

Bevorzugt wird das Grundelement des NMR-Rotors aus diamagnetischem Material ausgeführt sein. Passend zur Aufnahmebohrung im diamagnetischen "Grund-Spinner" kann dann aus einer Vielzahl von verschiedenen, unterschiedlichen nicht-diamagnetischen Einsätzen, vorzugsweise in Zylinderform mit entsprechenden Außendurchmessern je nach konkreter Mess-Anordnung individuell und optimal ausgewählt werden.

So können Schwankungen in der Suszeptibilität des Grundmaterials ideal und individuell ausgeglichen werden.

Die Merkmale aller oben beschriebenen Ausführungsformen der Erfindung können -jedenfalls größtenteils- auch miteinander kombiniert werden, sofern die Kombination unter den Schutzumfang der Patentansprüche fällt.

**Bezugszeichenliste:**

1    Probenbehälter
2    NMR-Rotor (="Spinner")
2a    Mantelteil des NMR-Rotors aus diamagnetischem Material
2b    Einsatz des NMR-Rotors aus nicht-diamagnetischem Material
2c    Aufnahme für einen Probenbehälter
3    NMR-Stator
4    HF-Sende- und Empfangs-Spulensystem
5    z-Achse der Anordnung
6    NMR-Probenkopf
7    NMR-Magnetsystem

**Referenzliste:**

Für die Beurteilung der Patentfähigkeit in Betracht gezogene Druckschriften

[1] US 6 741 079 B2 ≈ DE 101 30 283 C1

[2] US 5 517 856 A ≈ DE 195 09 062 C2

[3] US 9 500 726 B2 ≈ DE 10 2013 204 131 B3

[4] US 6,686,740 B2 ≈ DE 101 11 674 C2 ≈ EP 1 239 295 B1

[5] US 4 806 868 A; US-A 4 275 350 A; JP 61023952 A;
US 2004 / 0 178 793 A1; US 3 681 683 A

[6] JP 2001 235 526 A

[7] US 2002 / 0 063 561 A1

[8] JP 2006 029 964 A

[9] US 7 656 158 B2 ≈ EP 1 918 731 B1

[10] US 2009 / 0 066 333 A1

[11] US 2012 / 0 194 194 A1

[12] JP 2009 103 517 A

[13] DE 10 2014 201 076 B3

**Patentansprüche**

**1.**    NMR-Rotor (2) mit einer Aufnahme zur Einführung eines Probenbehälters (1) mit Probensubstanz für NMR-Messungen in einem homogenen Bereich eines NMR-Magnetfelds mit Flussdichte B, dessen Feldvektor im homogenen Bereich in vertikaler Richtung entlang einer z-Achse (5) verläuft, wobei der NMR-Rotor (2) beim Einbringen des Probenbehälters (1) in den homogenen Bereich des Magnetfelds Bereiche mit inhomogenen Magnetfeldanteilen und zumindest einem Flussdichtegradienten dB/dz durchläuft,
**dadurch gekennzeichnet,**
**dass** der NMR-Rotor (2) aus mindestens zwei unterschiedlichen Materialien aufgebaut ist, von denen ein Material diamagnetische und ein anderes Material nicht-diamagnetische Eigenschaften aufweist,
und **dass** die unterschiedlichen Materialien geometrisch derart im NMR-Rotor (2) verteilt angeordnet sind, dass die magnetische Kraft auf den NMR-Rotor (2) unter der Wirkung eines Produkts $\Phi_z$ aus magnetischer Flussdichte B und Flussdichtegradient dB/dz, dessen Betrag den Wert von 1400 T$^2$/m überschreitet, entweder in die gleiche Richtung wirkt wie die Gewichtskraft des NMR-Rotors (2), oder betragsmäßig kleiner ist als die Gewichtskraft des NMR-Rotors (2).

2. NMR-Rotor nach Anspruch 1, **dadurch gekennzeichnet, dass** das Produkt $\Phi_z$ gegeben ist durch

$$\Phi_z = \frac{1}{V_{Rotor}} \cdot \int_{V_{Rotor}} B \cdot \frac{dB(z)}{dz} \cdot dV$$

wobei gilt: $|\Phi_z| > 1400$ T$^2$/m, bevorzugt $|\Phi_z| > 1500$ T$^2$/m, besonders bevorzugt $|\Phi_z| > 2000$ T$^2$/m,

und wobei
$V_{Rotor}$ das Volumen des NMR-Rotors (2) und
dV ein infinitesimales Volumenelement des NMR-Rotors (2) bedeuten.

3. NMR-Rotor nach einem der vorhergehenden Ansprüche, **dadurch gekennzeichnet, dass** mindestens ein nicht-diamagnetisches Material des NMR-Rotors (2), vorzugsweise sämtliche nicht-diamagnetischen Materialien, paramagnetische Eigenschaften aufweisen.

4. NMR-Rotor nach einem der vorhergehenden Ansprüche, **dadurch gekennzeichnet, dass** mindestens ein diamagnetisches und mindestens ein nicht-diamagnetisches Material im NMR-Rotor (2) derart angeordnet sind, dass im NMR-Magnetfeld mit Flussdichte B eines Hochfeld-NMR-Magneten am Ort des NMR-Rotors (2) gilt:

$$\chi_{dia} \cdot \int_{V_{dia}} \frac{dB}{dr} \cdot dV + \chi_{non-dia} \cdot \int_{V_{non-dia}} \frac{dB}{dr} \cdot dV < 0$$

wobei

$\chi_{dia}$ die magnetischen Suszeptibilität des diamagnetischen Materials,
$\chi_{non-dia}$ die magnetischen Suszeptibilität des nicht-diamagnetischen Materials,
$V_{dia}$ das Volumen des diamagnetischen Materials im NMR-Rotor (2), $V_{non-dia}$ das Volumen des nicht-diamagnetischen Materials im NMR-Rotor (2),
dB/dr den Gradienten der Flussdichte des NMR-Magnetfeldes im Volumen des Rotors (2) in radialer Richtung bezüglich der z-Achse (5) und
dV ein infinitesimales Volumenelement des NMR-Rotors (2) bedeuten.

5. NMR-Rotor nach einem der vorhergehenden Ansprüche, **dadurch gekennzeichnet, dass** mindestens eines der Materialien des NMR-Rotors (2), insbesondere das nicht-diamagnetische, elektrisch leitfähig ist, und dass dieses Material im NMR-Rotor (2) derart angeordnet ist, dass es die Aufnahme nicht vollständig umschließt.

6. NMR-Rotor nach einem der vorhergehenden Ansprüche, **dadurch gekennzeichnet, dass** der NMR-Rotor (2) eine Rotor-Achse im Zentrum der Aufnahme umfasst, die beim Einbringen des Probenbehälters (1) in den homogenen Bereich des Magnetfelds entlang der z-Achse (5) orientiert ist, dass der NMR-Rotor (2) spiegelsymmetrisch bezüglich einer die Rotor-Achse enthaltenden Symmetrie-Ebene und/oder rotationssymmetrisch bezüglich der Rotor-Achse aufgebaut ist, und dass das diamagnetische Material und das nicht-diamagnetische Material spiegelsymmetrisch und/oder rotationssymmetrisch um die Rotor-Achse im NMR-Rotor (2) verteilt ist.

7. NMR-Rotor nach den Ansprüchen 5 und 6, **dadurch gekennzeichnet, dass** eines der Materialien des NMR-Rotors (2), bevorzugt ein nicht-diamagnetisches, besonders bevorzugt ein nicht-diamagnetisches sowie elektrisch leitfähiges Material, als mindestens zwei stabförmige Teile ausgebildet und im Grundmaterial des NMR-Rotors (2) in parallel zur Rotor-Achse verlaufenden Parallelbohrungen angeordnet ist.

**8.** NMR-Rotor nach einem der Ansprüche 1 bis 6, **dadurch gekennzeichnet, dass** das nicht-diamagnetische und das diamagnetische Material des NMR-Rotors (2) zumindest teilweise -vorzugsweise homogen- gemischt sind, insbesondere Partikel in Kunststoff, bevorzugt nicht-diamagnetische Partikel in einem diamagnetischen Kunststoff.

**9.** NMR-Rotor nach einem der Ansprüche 1 bis 6, **dadurch gekennzeichnet, dass** die Materialien des NMR-Rotors (2) mit unterschiedlichen magnetischen Eigenschaften zumindest teilweise in einer oder mehreren Schichten aufgetragen sind.

**10.** NMR-Rotor nach einem der vorhergehenden Ansprüche, **dadurch gekennzeichnet, dass** der NMR-Rotor (2) überwiegend aus einem der mindestens zwei Materialien mit unterschiedlichen magnetischen Eigenschaften aufgebaut ist, vorzugsweise aus einem diamagnetischen Material.

**11.** NMR-Rotor nach Anspruch 10, **dadurch gekennzeichnet, dass** der NMR-Rotor (2) zu einem Anteil zwischen 90 und 95 Volumen%, vorzugsweise zu etwa 92,5 Volumen%, aus dem einen der mindestens zwei Materialien mit unterschiedlichen magnetischen Eigenschaften aufgebaut ist und zu einem Anteil von 5 bis 10 Volumen%, vorzugsweise zu etwa 7,5 Volumen%, aus dem anderen Material.

**12.** NMR-Rotor nach einem der vorhergehenden Ansprüche, **dadurch gekennzeichnet, dass** das diamagnetische Material Kunststoff, beispielsweise POM, PEEK oder PCTFE, und/oder keramischen Werkstoff wie Glaskeramik, insbesondere mit in einer Borosilikat-Matrix eingelagertem Glimmer, oder eine bearbeitbare Aluminiumnitrid-Keramik enthält.

**13.** NMR-Rotor nach einem der vorhergehenden Ansprüche, **dadurch gekennzeichnet, dass** das nicht-diamagnetische Material Titan, Aluminium oder Platin, enthält.

**14.** NMR-Rotor nach einem der vorhergehenden Ansprüche, **dadurch gekennzeichnet, dass** die geometrische Verteilung der Materialien im
NMR-Rotor (2) derart gestaltet ist, dass die magnetische Kraft auf den NMR-Rotor (2) zwischen 0,02N und 0,2N, vorzugsweise höchstens 0,05N, beträgt.

**15.** Verfahren zur Auslegung und Herstellung eines NMR-Rotors (2) nach einem der vorhergehenden Ansprüche, **dadurch gekennzeichnet, dass** zunächst die magnetische Suszeptibilität eines Grundmaterials des NMR-Rotors (2), vorzugsweise des diamagnetischen Materials, bestimmt wird, und dass anschließend eine magnetische Kompensation des Rotors (2) durch ein weiteres Material mit unterschiedlichen magnetischen Eigenschaften, vorzugsweise paramagnetisches Material, in Abhängigkeit eines Messergebnisses des Grundmaterials für den NMR-Rotor (2) individuell, insbesondere unter Berücksichtigung spezieller Eigenschaften eines verwendeten Hochfeld-NMR-Magneten, bestimmt wird und der NMR-Rotor (2) unter Verwendung der derart bestimmten Materialien aufgebaut wird.

**Claims**

**1.** NMR rotor (2) comprising a receptacle for introducing a sample container (1) having a sample substance for NMR measurements in a homogeneous region of an NMR magnetic field with flux density B, the field vector of which in the homogeneous region extends in the vertical direction along a z-axis (5), the NMR rotor (2) passing through regions with inhomogeneous magnetic field components and at least one flux density gradient dB/dz when the sample container (1) is introduced into the homogeneous region of the magnetic field,
**characterized in that**
the NMR rotor (2) is composed of at least two different materials, of which one material has diamagnetic properties and another material has non-diamagnetic properties,
and **in that** the different materials are arranged so as to be geometrically distributed in the NMR rotor (2) in such a way that the magnetic force on the NMR rotor (2) under the effect of a product $\Phi_z$ of magnetic flux density B and flux density gradient dB/dz, the magnitude of which exceeds the value of 1400 T$^2$/m, either acts in the same direction as the weight force of the NMR rotor (2) or is smaller in magnitude than the weight force of the NMR rotor (2).

**2.** NMR rotor according to claim 1, **characterized in that** the product $\Phi_z$ is given by

$$\Phi_z = \frac{1}{V_{Rotor}} \cdot \int_{V_{Rotor}} B \cdot \frac{dB(z)}{dz} \cdot dV$$

where: $|\Phi_z| > 1400$ T$^2$/m, preferably $|\Phi_z| > 1500$ T$^2$/m, particularly preferably $|\Phi_z| > 2000$ T$^2$/m, and where
$V_{Rotor}$ represents the volume of the NMR rotor (2) and
dV represents an infinitesimal volume element of the NMR rotor (2).

3. NMR rotor according to either of the preceding claims, **characterized in that** at least one non-diamagnetic material of the NMR rotor (2), preferably all the non-diamagnetic materials, have paramagnetic properties.

4. NMR rotor according to any of the preceding claims, **characterized in that** at least one diamagnetic and at least one non-diamagnetic material are arranged in the NMR rotor (2) such that the following applies in the NMR magnetic field with flux density B of a high-field NMR magnet at the location of the NMR rotor (2):

$$\chi_{dia} \cdot \int_{V_{dia}} \frac{dB}{dr} \cdot dV + \chi_{non-dia} \cdot \int_{V_{non-dia}} \frac{dB}{dr} \cdot dV < 0$$

where

$\chi_{dia}$ represents the magnetic susceptibility of the diamagnetic material,
$\chi_{non-dia}$ represents the magnetic susceptibility of the non-diamagnetic material,
$V_{dia}$ represents the volume of the diamagnetic material in the NMR rotor (2),
$V_{non-dia}$ represents the volume of the non-diamagnetic material in the NMR rotor (2),
dB/dr represents the gradient of the flux density of the NMR magnetic field in the volume of the rotor (2) in the radial direction with respect to the z-axis (5) and
dV represents an infinitesimal volume element of the NMR rotor (2).

5. NMR rotor according to any of the preceding claims, **characterized in that** at least one of the materials of the NMR rotor (2), in particular the non-diamagnetic material, is electrically conductive, and **in that** this material is arranged in the NMR rotor (2) in such a way that it does not completely enclose the receptacle.

6. NMR rotor according to any of the preceding claims, **characterized in that** the NMR rotor (2) comprises a rotor axis in the center of the receptacle, which axis is oriented along the z-axis (5) when the sample container (1) is introduced into the homogeneous region of the magnetic field, **in that** the NMR rotor (2) is constructed mirror-symmetrically with respect to a plane of symmetry containing the rotor axis and/or rotationally symmetrically with respect to the rotor axis, and **in that** the diamagnetic material and the non-diamagnetic material is distributed mirror-symmetrically and/or rotationally symmetrically about the rotor axis in the NMR rotor (2).

7. NMR rotor according to claims 5 and 6, **characterized in that** one of the materials of the NMR rotor (2), preferably a non-diamagnetic material, particularly preferably a non-diamagnetic material and electrically conductive material, is formed as at least two rod-shaped parts and is arranged in the base material of the NMR rotor (2) in parallel bores extending in parallel with the rotor axis.

8. NMR rotor according to any of claims 1 to 6, **characterized in that** the non-diamagnetic and the diamagnetic material of the NMR rotor (2) are at least partially-preferably homogeneously-mixed, in particular particles in plastics material, preferably non-diamagnetic particles in a diamagnetic plastics material.

9. NMR rotor according to any of claims 1 to 6, **characterized in that** the materials of the NMR rotor (2) having different magnetic properties are at least partially applied in one or more layers.

10. NMR rotor according to any of the preceding claims, **characterized in that** the NMR rotor (2) is predominantly composed of one of the at least two materials having different magnetic properties, preferably of a diamagnetic material.

**11.** NMR rotor according to claim 10, **characterized in that** the NMR rotor (2) is composed of one of the at least two materials having different magnetic properties in a proportion between 90 and 95% by volume, preferably approximately 92.5% by volume, and is composed of the other material in a proportion of from 5 to 10% by volume, preferably approximately 7.5% by volume.

**12.** NMR rotor according to any of the preceding claims, **characterized in that** the diamagnetic material contains plastics material, for example POM, PEEK or PCTFE, and/or ceramic material such as glass ceramic material, in particular with mica embedded in a borosilicate matrix, or a machinable aluminum-nitride ceramic material.

**13.** NMR rotor according to any of the preceding claims, **characterized in that** the non-diamagnetic material contains titanium, aluminum or platinum.

**14.** NMR rotor according to any of the preceding claims, **characterized in that** the geometric distribution of the materials in the NMR rotor (2) is designed such that the magnetic force on the NMR rotor (2) is between 0.02 N and 0.2 N, preferably at most 0.05 N.

**15.** Method for the design and production of an NMR rotor (2) according to any of the preceding claims, **characterized in that** first the magnetic susceptibility of a base material of the NMR rotor (2), preferably the diamagnetic material, is determined, and **in that** subsequently a magnetic compensation of the rotor (2) by a further material having different magnetic properties, preferably paramagnetic material, is determined individually for the NMR rotor (2) depending on a measurement result of the base material, in particular taking into account special properties of a high-field NMR magnet used, and that the NMR rotor (2) is constructed using the materials determined in this way.

## Revendications

**1.** Rotor RMN (2) comportant un logement pour l'insertion d'un récipient d'échantillons (1) comportant une substance échantillon pour des mesures RMN dans une région homogène d'un champ magnétique RMN de densité de flux B, dont le vecteur de champ dans la région homogène s'étend dans la direction verticale le long d'un axe z (5), le rotor RMN (2), lors de l'introduction du récipient d'échantillons (1) dans la région homogène du champ magnétique, traversant des régions de composantes de champ magnétique inhomogènes et au moins un gradient de densité de flux dB/dz,
**caractérisé en ce que**
le rotor RMN (2) est construit à partir d'au moins deux matières différentes, parmi lesquelles une matière présente des propriétés diamagnétiques et une autre matière présente des propriétés non diamagnétiques, et **en ce que** les différentes matières sont disposées de manière répartie géométriquement dans le rotor RMN (2), de telle sorte que la force magnétique sur le rotor RMN (2) sous l'effet d'un produit $\Phi_z$ de la densité de flux magnétique B et du gradient de flux magnétique dB/dz, dont l'amplitude dépasse la valeur de 1400 T$^2$/m, soit agit dans le même sens que le poids du rotor RMN (2), soit est d'amplitude plus petite que le poids du rotor RMN (2).

**2.** Rotor RMN selon la revendication 1, **caractérisé en ce que** le produit $\Phi_z$ est défini par

$$\phi_z = \frac{1}{V_{Rotor}} \cdot \int_{V_{Rotor}} B \cdot \frac{dB(z)}{dz} \cdot dV$$

où l'on a : $|\phi_z| > 1400\,T^2/_m$, de préférence $|\phi_z| > 1500\,T^2/_m$, de manière particulièrement préférée $|\phi_z| > 200\,T^2/_m$, et où
$V_{Rotor}$ représente le volume du rotor RMN (2) et
dV représente un élément de volume infinitésimal du rotor RMN (2).

**3.** Rotor RMN selon l'une des revendications précédentes, **caractérisé en ce qu'**au moins une matière non diamagnétique du rotor RMN (2), de préférence toutes les matières non diamagnétiques, présentent des propriétés paramagnétiques.

**4.** Rotor RMN selon l'une des revendications précédentes, **caractérisé en ce qu'**au moins une matière diamagnétique et au moins une matière non diamagnétique sont disposés dans le rotor RMN (2) de telle sorte que, dans le flux magnétique RMN de densité de flux B d'un aimant RMN à haut champ à l'emplacement du rotor RMN (2), l'on a :

$$\chi_{dia} \cdot \int_{V_{dia}} \frac{dB}{dr} \cdot dV + \chi_{non-dia} \cdot \int_{V_{non-dia}} \frac{dB}{dr} \cdot dV < 0$$

où

$X_{dia}$ représente la susceptibilité magnétique de la matière diamagnétique,
$X_{non-dia}$ représente la susceptibilité magnétique de la matière non diamagnétique,
$V_{dia}$ représente le volume de la matière diamagnétique dans le rotor RMN (2),
$V_{non-dia}$ représente le volume de la matière non diamagnétique dans le rotor RMN (2),
dB/dr représente le gradient de la densité de flux du champ magnétique RMN dans le volume du rotor (2) dans la direction radiale par rapport à l'axe z (5) et
dV représente un élément de volume infinitésimal du rotor RMN (2) .

5. Rotor RMN selon l'une des revendications précédentes, **caractérisé en ce qu'**au moins une des matières du rotor RMN (2), en particulier la matière non diamagnétique, est électroconductrice, et **en ce que** cette matière est disposée dans le rotor RMN (2) de telle sorte qu'elle n'entoure pas complètement le logement.

6. Rotor RMN selon l'une des revendications précédentes, **caractérisé en ce que** le rotor RMN (2) comprend un axe de rotor au centre du logement, lequel axe est orienté le long de l'axe z (5) lors de l'introduction du récipient d'échantillons (1) dans la région homogène du champ magnétique, **en ce que** le rotor RMN (2) est construit de manière à présenter une symétrie miroir par rapport à un plan de symétrie contenant l'axe de rotor et/ou de manière à présenter une symétrie de révolution par rapport à l'axe de rotor, et **en ce que** la matière diamagnétique et la matière non diamagnétique sont réparties suivant une symétrie miroir et/ou suivant une symétrie de révolution autour de l'axe de rotor dans le rotor RMN (2).

7. Rotor RMN selon les revendications 5 et 6, **caractérisé en ce qu'**une des matières du rotor RMN (2), de préférence une matière non diamagnétique, de manière particulièrement préférée une matière non diamagnétique et électroconductrice, est réalisée sous la forme d'au moins deux parties en forme de barres et est disposée dans la matière de base du rotor RMN (2) dans des alésages parallèles s'étendant parallèlement à l'axe de rotor.

8. Rotor RMN selon l'une des revendications 1 à 6, **caractérisé en ce que** la matière non diamagnétique et la matière diamagnétique du rotor RMN (2) sont mélangées au moins partiellement, de préférence de manière homogène, en particulier des particules dans une matière synthétique, de préférence des particules non diamagnétiques dans une matière synthétique diamagnétique.

9. Rotor RMN selon l'une des revendications 1 à 6, **caractérisé en ce que** les matières du rotor RMN (2) présentant différentes propriétés magnétiques sont appliquées au moins partiellement en une ou plusieurs couches.

10. Rotor RMN selon l'une des revendications précédentes, **caractérisé en ce que** le rotor RMN (2) est construit principalement à partir d'une des au moins deux matières présentant différentes propriétés, de préférence à partir d'une matière diamagnétique.

11. Rotor RMN selon la revendication 10, **caractérisé en ce que** le rotor RMN (2) est construit à partir de l'une des au moins deux matières présentant différentes propriétés magnétiques dans une proportion entre 90 et 95 % en volume, de préférence jusqu'à approximativement 92,5 % en volume et à partir de l'autre matière dans une proportion de 5 à 10 % en volume, de préférence jusqu'à approximativement 7,5 % en volume.

12. Rotor RMN selon l'une des revendications précédentes, **caractérisé en ce que** la matière diamagnétique contient une matière synthétique, par exemple POM, PEEK ou PCTFE, et/ou un matériau céramique tel qu'une vitrocéramique, en particulier avec du mica incorporé dans une matrice de borosilicate, ou une céramique de nitrure d'aluminium pouvant être usinée.

13. Rotor RMN selon l'une des revendications précédentes, **caractérisé en ce que** la matière non diamagnétique contient du titane, de l'aluminium ou du platine.

14. Rotor RMN selon l'une des revendications précédentes, **caractérisé en ce que** la répartition géométrique des matières dans le rotor RMN (2) est configurée de telle sorte que la force magnétique sur le rotor RMN (2) vaut entre 0,02N et 0,2N, de préférence au maximum 0,05N.

15. Procédé de conception et de fabrication d'un rotor RMN (2) selon l'une des revendications précédentes, **caractérisé en ce que** tout d'abord la susceptibilité magnétique d'une matière de base du rotor RMN (2), de préférence de la matière diamagnétique, est déterminée, et **en ce qu'**ensuite une compensation magnétique du rotor (2) par le biais d'une autre matière présentant des propriétés magnétiques différentes, de préférence une matière paramagnétique, est déterminée en fonction d'un résultat de mesure de la matière de base pour le rotor RMN (2) individuellement, en particulier en tenant compte de propriétés spéciales d'un aimant RMN à haut champ utilisé, et le rotor RMN (2) est construit à l'aide des matières déterminées.

Fig. 1b

Fig. 1a

Stand der Technik

Fig. 2

Fig. 3

Fig. 4

| Parameter | Länge | Durchmesser | Wanddicke | Innendurchmesser | Dichte | Volumen1 | Volumen2 | Gewicht | Gewichtskraft |
|---|---|---|---|---|---|---|---|---|---|
| Einheit | **mm** | **mm** | **mm** | **mm** | **kg/m3** | **mm3** | **mm3** | **g** | **N** |
| Probenröhrchen (Glas) | 200,0 | 2,950 | 0,295 | 2,360 | 2500,0 | 1367,0 | 874,9 | 1,23 | 0,012 |
| Probenvolumen (Wasser) | 40,0 | | | 2,360 | 997,0 | | 175,0 | 0,17 | 0,002 |
| Spinner (PCTFE) | 50,0 | 16,0 | 6,5 | 3,000 | 2130,0 | 10053,1 | 353,4 | 20,66 | 0,203 |

# Fig. 5

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 6741079 B2
- DE 10130283 C1
- US 5517856 A
- DE 19509062 C2
- US 9500726 B2
- DE 102013204131 B3
- US 6686740 B2
- DE 10111674 C2
- EP 1239295 B1
- US 4806868 A
- US 4275350 A
- JP 61023952 A

- US 20040178793 A1
- US 3681683 A
- JP 2001235526 A
- US 20020063561 A1
- JP 2006029964 A
- US 7656158 B2
- EP 1918731 B1
- US 20090066333 A1
- JP 2009103517 A
- DE 102014201076 B3
- US 20120194194 A1